# EUROPEAN PATENT APPLICATION

(11) **EP 4 040 613 A1**
(43) Date of publication of application: **10.08.2022**
(21) Application number: 20871251.3
(22) Date of filing: 29.09.2020
(51) Int. Cl.: H01S 5/022

(54) **OPTICAL ELEMENT MOUNTING PACKAGE, ELECTRONIC DEVICE, AND ELECTRONIC MODULE**

(30) Priority: 30.09.2019 JP 2019178922
(71) Applicant: Kyocera Corporation, Kyoto-shi Kyoto 612-8501 (JP)
(72) Inventor: KITAGAWA, Akihiko, Kyoto-shi, Kyoto 612-8501 (JP); KIMURA, Takashi, Kyoto-shi, Kyoto 612-8501 (JP)
(74) Representative: Viering, Jentschura & Partner mbB Patent- und Rechtsanwälte
(86) International application number: PCT/JP2020/036790
(87) International publication number: WO 2021/065855

(57) **Abstract**

An optical-device-mounting package includes a base member having an upper surface and a slope, the slope being continuous with the upper surface and sloping downward in a direction away from the upper surface; and an optical component having a first face and a second face, the second face being positioned opposite the first face. At least a part of the optical component is at a position higher than the upper surface, with at least a part of the second face being bonded to the slope with a bonding material. The bonding material spreads from an area between the second face and the slope up to an area between the second face and the base member and higher than the upper surface.

## Description

### TECHNICAL FIELD

The present disclosure relates to an optical-device-mounting package, an electronic device, and an electronic module.

### BACKGROUND ART

A TO (transistor outline)-can semiconductor laser including a laser chip is disclosed by Japanese Unexamined Patent Application Publication No. 2004-031900. TO-can packages exhibit poor heat dissipation. Therefore, TO-can packages employed for mounting high-power laser chips thereinside tend to be large so as to achieve satisfactory heat dissipation.

### SUMMARY OF INVENTION

An optical-device-mounting package according to the present disclosure includes:
a base member having an upper surface and a slope, the slope being continuous with the upper surface and sloping downward in a direction away from the upper surface; and
an optical component having a first face and a second face, the second face being positioned opposite the first face,
wherein at least a part of the optical component is at a position higher than the upper surface, with at least a part of the second face being bonded to the slope with a bonding material, and
wherein the bonding material spreads from an area between the second face and the slope up to an area between the second face and the base member and higher than the upper surface.

An electronic device according to the present disclosure includes:
the above optical-device-mounting package; and
an optical device mounted in the optical-device-mounting package.

An electronic module according to the present disclosure includes:
the above electronic device; and
a module substrate on which the electronic device is mounted.

### BRIEF DESCRIPTION OF DRAWINGS

[Fig. 1] Fig. 1 is an exploded perspective view of an electronic device according to an embodiment of the present disclosure.
[Fig. 2] Fig. 2 is a vertical sectional view of the electronic device illustrated in Fig. 1.
[Fig. 3] Fig. 3 is an enlargement of a structure for mounting an optical component according to the embodiment.
[Fig. 4] Fig. 4 is another enlargement, illustrating the thickness of a bonding material for bonding the optical component.
[Fig. 5] Fig. 5 is yet another enlargement, illustrating the position of an end face of the bonding material.
[Fig. 6A] Fig. 6A is a diagram of a comparative example, illustrating the shape of a bank and effects produced by the bank.
[Fig. 6B] Fig. 6B is a diagram of the embodiment, illustrating the shape of a bank and effects produced by the bank.
[Fig. 7] Fig. 7 is a diagram illustrating effects produced by the structure for mounting the optical component according to the present embodiment.
[Fig. 8] Fig. 8 is a vertical sectional view of an electronic module according to another embodiment of the present disclosure.

### DESCRIPTION OF EMBODIMENTS

Embodiments of the present disclosure will now be described in detail with reference to the drawings.

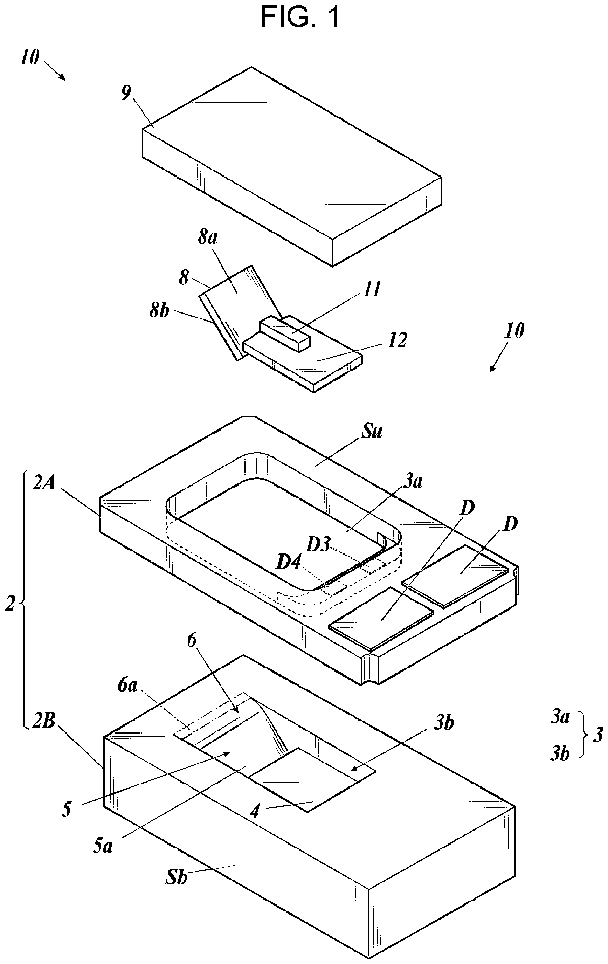

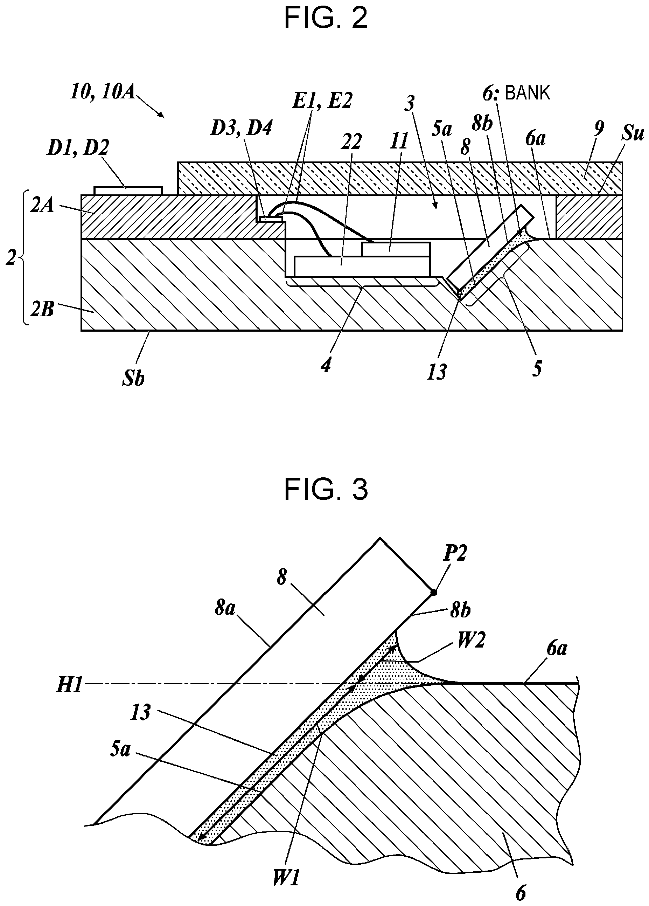

Fig. 1 is an exploded perspective view of an electronic device according to an embodiment of the present disclosure. Fig. 2 is a vertical sectional view of the electronic device according to the embodiment. The following description is based on a definition that a direction perpendicular to a mounting surface for mounting an optical device 11 (the upper surface of a sub mount 12) is the vertical direction, a side toward which a first major surface Su of a base member 2 faces is the upper side, and a side toward which a second major surface Sb of the base member 2 faces is the lower side. Note that the directions referred to in the following description do not necessarily need to coincide with directions of an electronic device 10 that is oriented for practical use.

An electronic device 10 according to a first embodiment includes an optical-device-mounting package 10A and an optical device 11. The optical device 11 is mounted in the optical-device-mounting package 10A. The optical-device-mounting package 10A includes a base member 2, an optical component 8, and a lid 9. The base member 2 has a first major surface Su, a second major surface Sb, and a recess 3. The second major surface Sb is positioned opposite the first major surface Su. The recess 3 provides an opening in the first major surface Su. The optical component 8 is mounted in the recess 3. The lid 9 covers the opening at the recess 3. The lid 9 is made of a material (glass or resin) that transmits light, and is bonded to the first major surface Su of the base member 2 with a bonding material.

The base member 2 chiefly includes a base upper member 2A and a base lower member 2B. The base upper member 2A is made of an insulating material. The base lower member 2B is made of metal. The base upper member 2A has a through-hole 3a (Fig. 1). The through-hole 3a extends through the base upper member 2A in a top-to-bottom direction. The base lower member 2B has a depression 3b (Fig. 1). The depression 3b is to be continuous with the through-hole 3a. If the base upper member 2A and the base lower member 2B are bonded to each other, the depression 3b and the through-hole 3a become continuous with each other, whereby the recess 3 is provided in such a manner as to be open upward.

A major part of the base upper member 2A is made of a ceramic material such as sintered aluminum oxide (alumina ceramic), sintered aluminum nitride, sintered mullite, or sintered glass-ceramic. The major part is obtained by, for example, punching or molding a ceramic green sheet, which is a ceramic material that is yet to be sintered, into a predetermined shape and sintering the sheet. The base upper member 2A further has electrodes D1 to D4 (Figs. 1 and 2) and wire conductors. The electrodes D1 to D4 are provided on the first major surface Su. The wire conductors run inside the base upper member 2A. The conductors are obtained by applying or feeding conductive paste to predetermined positions of the ceramic green sheet that is yet to be sintered, and then sintering the ceramic green sheet having the conducting paste thereon. The notches at corner edges of the base upper member 2A may be omitted.

The base lower member 2B is made of a metal material having high thermal conductivity, such as copper or aluminum, and is formed by, for example, pressing. The depression 3b provided in the base lower member 2B has a first mounting portion 4, a second mounting portion 5, and a bank 6. The optical device 11 is mounted on the first mounting portion 4 with a sub mount 12 interposed therebetween. The optical component 8 is mounted on the second mounting portion 5. The bank 6 is positioned across the second mounting portion 5 from the first mounting portion 4. The base lower member 2B may be made of the same ceramic material as that for the base upper member 2A. If the base lower member 2B is made of a ceramic material, the base lower member 2B can be formed by molding or the like. If the base upper member 2A and the base lower member 2B are to be provided as sintered bodies of the same kind, the two may be formed together as an integral body.

The optical device 11 is, for example, a laser diode (semiconductor laser). The optical device 11 may be any light-emitting device that is directional. The optical device 11 is bonded to the upper surface of the sub mount 12 with a bonding material. The sub mount 12 is bonded to the upper surface of the first mounting portion 4 with a bonding material. The direction of light emission from the optical device 11 is a direction parallel to the upper surface of the first mounting portion 4 or the upper surface of the sub mount 12 (for example, a horizontal direction) and is heading toward the second mounting portion 5. The optical device 11 is electrically connected to the electrodes D3 and D4, which are provided in the recess 3 and on the base upper member 2A, with bonding wires E1 and E2 and with wire conductors running through the sub mount 12. The electrodes provided inside the recess 3 are connected to the electrodes D1 and D2, which are provided outside the recess 3, with wire conductors. If power is inputted to the optical device 11 through the electrodes D1 and D2, the optical device 11 is activated.

The optical component 8 is a flat mirror having a first face 8a and a second face 8b. The second face 8b is positioned opposite the first face 8a. The optical component 8 receives light from the optical device 11 and reflects the light upward. The first face 8a may have a reflective surface or a surface with reflective coating. The second face 8b may be regarded as a bonding surface. The light reflected as above travels upward through the lid 9 to the outside of the electronic device 10. The optical component 8 may include a flat base body and a reflective film provided over one face of the base body. The base body is made of, for example, glass; metal such as Al, Ag, or Si; or an organic material. If the base body is made of metal, the reflective film may be omitted. The reflective surface may be flat. The reflective film has a surface serving as the reflective surface. The reflective film may be a film of metal such as Ag, Al, Au, Pt, or Cr; or a film of a dielectric material such as TiO₂, Ta₂O₅, or Nb₂O₅. The reflective film may be formed by a thin-film-forming technique such as deposition, sputtering, or plating.

The first mounting portion 4 has a flat upper surface spreading in, for example, the horizontal direction. The optical device 11 is bonded to the upper surface of the first mounting portion 4 with the sub mount 12 interposed therebetween. The flat surface referred to herein is a concept including a surface that is strictly flat, and a surface that is regarded as flat if small irregularities are ignored.

The second mounting portion 5 has a slope 5a. The slope 5a is angled with respect to the horizontal direction. The optical component 8 is bonded to the slope 5a with a bonding material 13. The slope 5a slopes downward from a bank top 6a toward the first mounting portion 4. The bank top 6a is an example of the upper surface according to the present disclosure.

The bank 6 is a raised portion positioned across the second mounting portion 5 from the first mounting portion 4 and is at a higher position than the first mounting portion 4. The bank top 6a is continuous with the slope 5a. The bank top 6a may be either a flat surface that is parallel to the upper surface of the second mounting portion 5 or a surface that is not parallel to the upper surface of the second mounting portion 5. The bank top 6a may be a part of the upper surface of the base lower member 2B and not overlapping the base upper member 2A.

### <Structure for Mounting Optical Component>

Fig. 3 is an enlargement of a structure for mounting the optical component.

The optical component 8 has the second face 8b positioned opposite the first face 8a. At least a part of the second face 8b is bonded to the slope 5a with the bonding material 13. The second face 8b may be flat. The bonding material 13 may be solder such as SnAgCu or AuSu; sintered metal nanoparticles chiefly composed of Au, Ag, or Cu; or an inorganic adhesive chiefly composed of alumina or zirconia.

The second face 8b of the optical component 8 has an upper end P2, which is at a position higher than the bank top 6a. The bonding material 13 spreads from an area between the second face 8b and the slope 5a up to an area between the second face 8b and the base member 2 and higher than the bank top 6a. The bonding material 13 may be present over an area W1, which spreads between the slope 5a and the second face 8b, and an area W2, which spreads along the second face 8b from a position higher than the bank top 6a down to the bank top 6a. The position higher than the bank top 6a refers to a position higher than a horizontal line H1, which is an extension of the bank top 6a, with the mounting surface for the optical device 11 being regarded as horizontal. If the bank top 6a is not horizontal, the horizontal line H1 refers to a line horizontally extended from a point of the bank top 6a that is closest to the slope 5a.

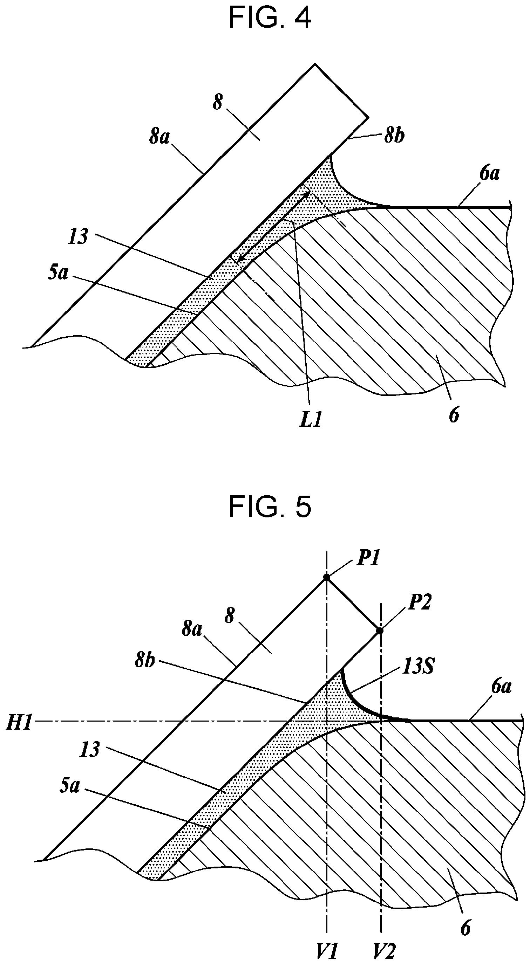

Fig. 4 is another enlargement, illustrating the thickness of the bonding material for bonding the optical component.

As illustrated in Fig. 4, the slope 5a and the bank top 6a are connected to each other in a region L1. In the region L1, the bonding material 13 provided between the second face 8b of the optical component 8 and the bank 6 has a thickness that gradually increases from a portion on the slope 5a toward a portion on the bank top 6a.

Fig. 5 is yet another enlargement, illustrating the position of an end face of the bonding material.

As illustrated in Fig. 5, the bonding material 13 spreads up to a position farther from the first face 8a of the optical component 8 than a virtual vertical line (a line perpendicular to the mounting surface for the optical device 11) V1, which passes through an upper end P1 of the first face 8a. Specifically, in a vertical section that is perpendicular to the slope 5a, the bonding material 13 has an exposed end face 13S. The exposed end face 13S may be positioned farther from the first face 8a than the virtual vertical line V1. In addition, the exposed end face 13S may be present at a position higher than the bank top 6a (higher than the horizontal line H1). In Fig. 5, the exposed end face 13S of the bonding material 13 is illustrated by a bold line.

The edge (upper edge) of the bonding material 13 on the second face 8b is at a position closer to the first face 8a of the optical component 8 than a virtual vertical line (a line perpendicular to the mounting surface for the optical device 11) V2, which passes through the upper end P2 of the second face 8b. Specifically, in the vertical section illustrated in Fig. 5, at least a part of the exposed end face 13S of the bonding material 13 may be at a position closer to the first face 8a than the virtual vertical line V2.

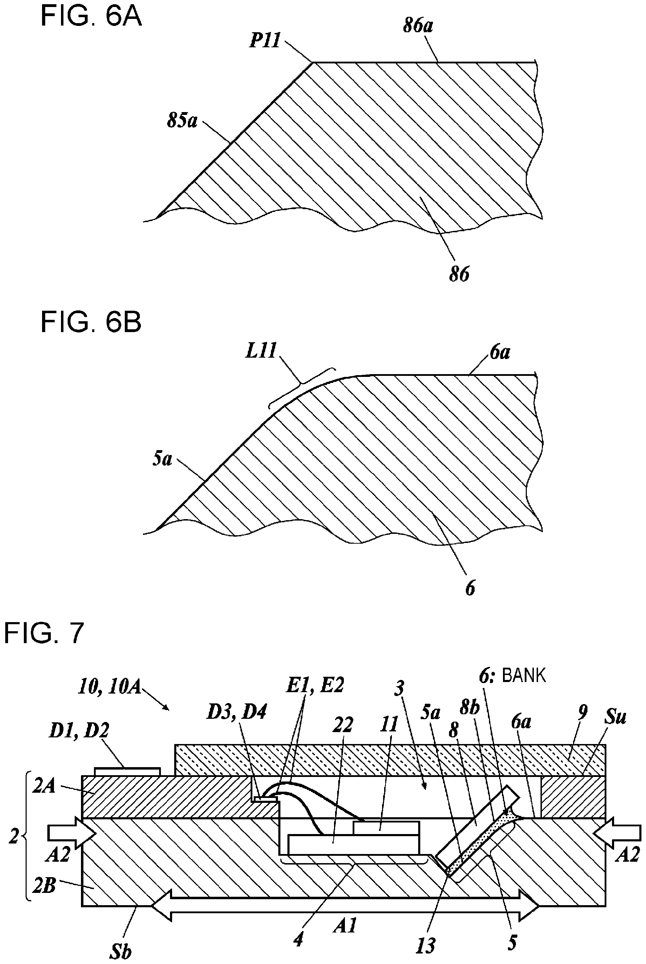

Fig. 6A is a diagram of a comparative example, illustrating the shape of a bank and effects produced by the bank. Fig. 6B is a diagram of the present embodiment, illustrating the shape of the bank and effects produced by the bank.

As illustrated in Fig. 6B, the bank 6 included in the base member 2 according to the present embodiment includes a convex curved surface L11. In vertical sectional view, the convex curved surface L11 is provided at the connection between the slope 5a and the bank top 6a and forms a gentle continuous slope. It is defined that the convex curved surface L11 is included in the slope 5a.

### <Effects of Structure for Mounting Optical Component>

Fig. 7 is a diagram illustrating effects produced by the structure for mounting the optical component according to the present embodiment. If the electronic device 10 comes to have a high temperature, the bonding material 13 is subjected to a stress acting in a direction A1 in accordance with the difference in the coefficient of thermal expansion between the base lower member 2B and the optical component 8. The stress acting in the direction A1 causes the base lower member 2B to expand in the horizontal direction. In another situation, if the electronic device 10 is grabbed in a process of mounting the electronic device 10 or any other process, the bonding material 13 is subjected to a stress acting in a direction A2. The stress acting in the direction A2 causes the base lower member 2B to contract in the horizontal direction.

Here, the stresses acting in the horizontal directions A1 and A2 will be discussed by decomposing each of the stresses into a component acting in the thickness direction of the bonding material 13 (a direction perpendicular to the slope 5a) and a component acting in the spreading direction of the bonding material 13. Since the directions of the respective components are angled with respect to the direction of the stress, neither of the two components of the stress becomes zero. That is, the bonding material 13 is subjected to a stress acting in the thickness direction as well. Such a stress acting in the thickness direction of the bonding material 13 is to be absorbed by a portion of the bonding material 13 that has a short length.

In the present embodiment, as illustrated in Fig. 3, the bonding material 13 is present in the area W2 spreading at a position higher than the bank top 6a and between the second face 8b of the optical component 8 and the bank top 6a. Therefore, the bonding material 13 has a satisfactory thickness in the above area. Such an arrangement increases the strength of the bonding material 13. With the increased strength of the bonding material 13, the optical component 8 is less likely to be displaced by any stress that may be applied to the bonding material 13 in the horizontal direction A1 or A2.

In the present embodiment, as illustrated in Fig. 4, the thickness of the bonding material 13 in the region L1 at the connection between the slope 5a and the bank top 6a gradually increases from the portion on the slope 5a toward the portion on the bank top 6a. That is, while the thickness of the bonding material 13 is increased at the exposed end face 13S, there is no sudden discontinuity in the thickness of the bonding material 13. If there is a sudden discontinuity, the stress may be concentrated at the point of sudden discontinuity, which may lower the tolerance of the bonding material 13 to stress. The probability that such a situation may occur is reduced by the gradually increasing thickness.

In the present embodiment, as illustrated in Fig. 5, the bonding material 13 spreads up to a position farther from the first face 8a than the virtual vertical line V1 and higher than the bank top 6a. The stress that may be applied from the bonding material 13 to the optical component 8 is largest at a position close to an end of the bonding area (the exposed end face 13S of the bonding material 13). In the above arrangement of the bonding material 13, however, the stress is less likely to act on the first face 8a. Therefore, the first face 8a is less likely to be strained by the stress.

In the present embodiment, as illustrated in Fig. 5, the edge of the bonding material 13 on the second face 8b is at a position closer to the first face 8a than the virtual vertical line V2 and higher than the bank top 6a. The stress that may be applied from the bonding material 13 to the second face 8b of the optical component 8 increases proportionally to the distance from the center of the bonding area. Furthermore, the strength of the second face 8b of the optical component 8 decreases toward the edge thereof. Nevertheless, the above arrangement of the bonding material 13 reduces the stress that may be applied from the bonding material 13 to a part near the edge of the second face 8b. Therefore, such a part of the optical component 8 is less likely to be deformed by the stress that may be applied from the bonding material 13.

In the present embodiment, as illustrated in Fig. 6B, the convex curved surface L11 is provided at the connection between the slope 5a and the bank top 6a. Referring to Fig. 6A illustrating a bank 86 according to the comparative example, suppose that there is a point of discontinuity P11 at the connection between a slope 85a and a bank top 86a, and the optical component 8 is bonded to such a slope with the bonding material 13. In such a case, the stress tends to be concentrated at the point of discontinuity P11. If the stress concentrated at the point of discontinuity P11 is transmitted through the bonding material 13 to the optical component 8, the optical component 8 may be strained. In contrast, the bank 6 according to the present embodiment has the convex curved surface L11 between the slope 5a and the bank top 6a, which moderates the discontinuity in the slope. Therefore, although the bonding material 13 is present not only between the slope 5a and the second face 8b but also between the bank top 6a and the second face 8b, the stress is not concentrated at the connection between the slope 5a and the bank top 6a. Hence, any stress applied from the bank top 6a and transmitted through the bonding material 13 to the optical component 8 is dispersed, reducing the probability that the optical component 8 may be strained.

To summarize, in the electronic device 10 according to the present embodiment, since the optical device 11 and the optical component 8 are mounted in a package including the base member 2 and the lid 9, the direction of light emission is changeable by the optical component 8, which increases the degree of freedom in the orientation of the optical device 11. That is, it is possible to orient the optical device 11 perpendicularly to the direction of light emission. Thus, the base member 2 having the recess 3 that is highly heat dissipative can be employed as a package. Hence, even if the optical device 11 that outputs high power is employed, the size of the electronic device 10 is kept small because of the highly heat-dissipative characteristic of the base member 2. In the present embodiment, with the above improvement in the structure for bonding the optical component 8, the optical component 8 is bonded with increased strength.

### <Electronic Module>

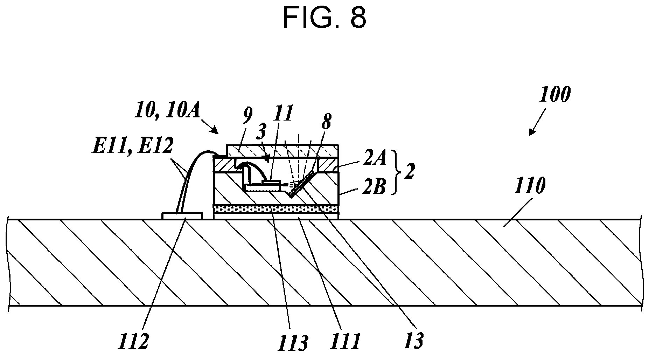

Fig. 8 is a vertical sectional view of an electronic module according to another embodiment of the present disclosure.

An electronic module 100 according to an embodiment of the present disclosure is obtained by mounting the electronic device 10 on a module substrate 110. The module substrate 110 carrying the electronic device 10 may also carry other electronic devices, electronic elements, electric elements, and so forth. The module substrate 110 may be provided with electrode pads 111 and 112. The electronic device 10 may be bonded to the electrode pad 111 with a bonding material 113, such as solder. Furthermore, the electrodes D1 and D2 of the electronic device 10 may be connected to the electrode pad 112 on the module substrate 110 with bonding wires E11 and E12, through which signals may be outputted from the module substrate 110 to the electronic device 10.

The electronic module 100 according to the present embodiment includes the electronic device 10 that is highly heat dissipative and has increased strength in the bonding of the optical component. Therefore, the electronic module 100 provides high reliability.

While embodiments of the present disclosure have been described above, the optical-device-mounting package, the electronic device, and the electronic module according to the present disclosure are not limited to those described in the above embodiments. For example, while the above embodiments relate to a configuration in which the optical device is a laser diode, the optical device may be any of various other directional light-emitting devices such as a light-emitting diode. While the above embodiments relate to a configuration in which the optical component is a plate-shaped mirror, the optical component may be, for example, a mirror having a first face and a second face that are not parallel to each other, or a light-guiding member such as a prism. Other features, including the shape of the base member and the structure of packaging the optical device and the optical component, may be changed in any way.

### INDUSTRIAL APPLICABILITY

The present disclosure is applicable to an optical-device-mounting package, an electronic device, and an electronic module.

### REFERENCE SIGNS LIST

2 base member
2A base upper member
2B base lower member
3 recess
4 first mounting portion
5 second mounting portion 5a slope
6 bank
6a bank top (upper surface)
8 optical component
8a first face
8b second face
9 lid
10 electronic device
10A optical-device-mounting package
11 optical device
12 sub mount
13 bonding material
H1 horizontal line at bank top
W1, W2 area where bonding material is present
L1 region at and around connection between slope and bank top
L11 convex curved surface
P1 upper end of first face
P2 upper end of second face
V1, V2 virtual vertical line

## Claims

1. An optical-device-mounting package comprising:
a base member having an upper surface and a slope, the slope being continuous with the upper surface and sloping downward in a direction away from the upper surface; and
an optical component having a first face and a second face, the second face being positioned opposite the first face,
wherein at least a part of the optical component is at a position higher than the upper surface, with at least a part of the second face being bonded to the slope with a bonding material, and
wherein the bonding material spreads from an area between the second face and the slope up to an area between the second face and the base member and higher than the upper surface.

2. The optical-device-mounting package according to Claim 1,
wherein the bonding material has a thickness that gradually increases from a portion on the slope toward a portion on the upper surface.

3. The optical-device-mounting package according to Claim 1 or 2,
wherein the optical component is a mirror, and
wherein the bonding material spreads up to a position farther from the first face of the optical component than a virtual vertical line passing through an upper end of the first face.

4. The optical-device-mounting package according to Claim 1 or 2,
wherein the optical component is a mirror, and
wherein an edge of the bonding material on the second face of the optical component is at a position closer to the first face than a virtual vertical line passing through an upper end of the second face.

5. The optical-device-mounting package according to any of Claims 1 to 4,
wherein a connection between the upper surface and the slope forms a convex curved surface in sectional view.

6. An electronic device comprising:
the optical-device-mounting package according to any of Claims 1 to 5; and
an optical device mounted in the optical-device-mounting package.

7. An electronic module comprising:
the electronic device according to Claim 6; and
a module substrate on which the electronic device is mounted.
